(19) Europäisches Patentamt / European Patent Office / Office européen des brevets

(11) **EP 3 596 408 B1**

(12) **FASCICULE DE BREVET EUROPEEN**

(45) Date de publication et mention de la délivrance du brevet:
**26.05.2021 Bulletin 2021/21**

(51) Int Cl.:
*F24S 70/20* *(2018.01)*   *F24S 40/50* *(2018.01)*

(21) Numéro de dépôt: **18712990.3**

(22) Date de dépôt: **12.03.2018**

(86) Numéro de dépôt international:
**PCT/FR2018/050564**

(87) Numéro de publication internationale:
**WO 2018/167411 (20.09.2018 Gazette 2018/38)**

(54) **MATERIAU MULTICOUCHE**

MEHRSCHICHTIGES MATERIAL

MULTILAYER MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.03.2017 FR 1752026**

(43) Date de publication de la demande:
**22.01.2020 Bulletin 2020/04**

(73) Titulaires:
- **Viessmann Faulquemont**
  **57380 Faulquemont (FR)**
- **Centre National de la Recherche Scientifique**
  **75794 Paris (FR)**
- **Université de Lorraine**
  **54000 Nancy (FR)**

(72) Inventeurs:
- **MERCS, David**
  **57380 Faulquemont (FR)**
- **CAPON, Fabien**
  **54740 Germonville (FR)**
- **PORTHA, Nicolas**
  **57385 Tritteling Redlach (FR)**
- **BOILEAU, Alexis**
  **88200 Remiremont (FR)**

(74) Mandataire: **Cabinet Bleger-Rhein-Poupon**
**4a rue de l'Industrie**
**67450 Mundolsheim (FR)**

(56) Documents cités:
**WO-A1-2014/140499**

- **Aline Rougier ET AL: "2014 Spring Meeting Lille, France - May 26 th -30 th SYMPOSIUM L Chromogenic Materials and Devices Symposium Organizers", , 26 mai 2014 (2014-05-26), XP055423380, Extrait de l'Internet: URL:https://www.european-mrs.com/sites/default/files/pdf/symposium_l.pdf [extrait le 2017-11-09]**
- **TANG G ET AL: "The thermochromic properties of La"1"-"xSr"xMnO"3 compounds", SOLAR ENERGY MATERIALS AND SOLAR CELLS, ELSEVIER SCIENCE PUBLISHERS, AMSTERDAM, NL, vol. 92, no. 10, 1 octobre 2008 (2008-10-01), pages 1298-1301, XP022938594, ISSN: 0927-0248, DOI: 10.1016/J.SOLMAT.2008.05.001 [extrait le 2008-06-18]**
- **FAN DESONG ET AL: "Temperature-dependent infrared properties of Ca doped (La,Sr)MnO3compositions with potential thermal control application", APPLIED THERMAL ENGINEERING, PERGAMON, OXFORD, GB, vol. 51, no. 1, 7 septembre 2012 (2012-09-07), pages 255-261, XP028971158, ISSN: 1359-4311, DOI: 10.1016/J.APPLTHERMALENG.2012.07.046**
- **LI QIANG ET AL: "Thermal radiative properties of plasma sprayed thermochromic coating", JOURNAL OF ALLOYS AND COMPOUNDS, vol. 583, 28 août 2013 (2013-08-28), pages 516-522, XP028747874, ISSN: 0925-8388, DOI: 10.1016/J.JALLCOM.2013.08.113**

EP 3 596 408 B1

- LIM D P ET AL: "Influence of post-treatments on the contact resistance of plasma-sprayed La"0"."8Sr"0"."2MnO"3 coating on SOFC metallic interconnector", SURFACE AND COATINGS TECHNOLOGY, ELSEVIER BV, AMSTERDAM, NL, vol. 200, no. 5-6, 21 novembre 2005 (2005-11-21), pages 1248-1251, XP027608650, ISSN: 0257-8972 [extrait le 2005-11-21]
- CAPON F ET AL: "Thermochromic properties of rare earth perovskites", EUROPEAN MATERIALS RESEARCH SOCIETY CONFERENCE, SPRING 2014; LILLE, FRANCE - MAY 26TH - 30TH 2014; SYMPOSIUM L CHROMOGENIC MATERIALS AND DEVICES, , 1 janvier 2014 (2014-01-01), pages 1-46, XP009501431, Extrait de l'Internet: URL:https://www.researchgate.net/publicati on/283205883_Thermochromic_properties_of_r are_earth_perovskite
- LAFFEZ PATRICK ET AL: "Electron doped (Sm1-x,Cax)MnO3 perovskite manganite as potential infrared thermochromic switch", APPLIED PHYSICS LETTERS, A I P PUBLISHING LLC, US, vol. 89, no. 8, 24 août 2006 (2006-08-24), pages 81909-081909, XP012088594, ISSN: 0003-6951, DOI: 10.1063/1.2236290

**Description**

Un rayon lumineux est constitué par une ou plusieurs onde(s) lumineuse(s) qualifié(es) « d'onde électromagnétique ». Une onde électromagnétique est constituée par un champ électrique et un champ magnétique et est caractérisée par sa période temporelle t et sa période spatiale nommée longueur d'onde X.

Il existe en particulier trois types d'ondes lumineuses définies par la valeur de leur longueur d'onde $\lambda$ :

- Les ondes visibles correspondant à des $\lambda$ compris entre 380 et 780 nm,
- Les ultras violets correspondant à des $\lambda$ inferieures à 380 nm,
- Les infra-rouges correspondant à des $\lambda$ supérieures à 780 nm.

Chaque rayon lumineux comprend un ou plusieurs faisceaux lumineux composé(s) de photons. Chaque photon possède une énergie E = hv, avec h la constante de Planck et v la fréquence de l'onde lumineuse en Hertz. L'énergie d'un photon dépend donc de la longueur d'onde $\lambda$.

Un faisceau lumineux est donc un flux de photons et se caractérise par un « flux énergétique $\phi$ » représentant la quantité d'énergie que transporte un faisceau lumineux par unité de temps.

Tout corps à une température T soumis à un rayon lumineux incident de longueur d'onde $\lambda$ et d'énergie E, peut en absorber, en transmettre ou encore en réfléchir une partie selon la relation suivante :

$$\text{E totale } (\lambda, T) = \text{Et } (\lambda, T) + \text{Ea } (\lambda, T) + \text{Er}(\lambda, T)$$

$$= \Gamma. \text{ E totale } (\lambda, T) + \alpha. \text{ E totale } (\lambda, T) + \rho. \text{ E totale } (\lambda, T).$$

L'énergie totale « E totale » d'un rayon lumineux arrivant sur un matériau correspond à la somme de l'énergie transmise (Et $(\lambda, T)$), de l'énergie absorbée (Ea $(\lambda, T)$) et de l'énergie réfléchie (Er $(\lambda, T)$) par ce matériau, à une longueur d'onde $\lambda$ et une température T données.

Lorsqu'un rayon lumineux incident, c'est-à-dire un flux énergétique $\phi$ arrive en contact avec un corps présentant une température T, on peut définir les grandeurs suivantes :

- La <u>transmittance</u> ou « coefficient de transmission » : $\Gamma$ $\Gamma$ = ($\phi t/\phi 0$) ; avec $\phi t$ correspondant au flux énergétique transmis traversant la matière, et $\phi 0$ correspondant au flux énergétique incident apporté par le rayon incident. La transmittance dépend de la longueur d'onde $\lambda$ du rayon lumineux incident, de la température, de l'épaisseur et de la composition de la matière ou du corps, elle correspond à la fraction d'énergie issue d'un rayon lumineux capable de traverser la matière ou le corps.

- L'<u>absorbance</u> ou « coefficient d'absorption » : $\alpha$ $\alpha$ = log (1/T) = log ($\phi_0/ \phi$). Ceci correspond au rapport du flux énergétique absorbé sur le flux énergétique incident.
  L'absorbance d'un matériau dépend de la longueur d'onde $\lambda$ du rayon lumineux incident, de la température, de l'épaisseur et de la composition de la matière dudit matériau, elle correspond à la fraction d'énergie issue d'un rayon lumineux capable d'être absorbé par ledit matériau considéré.

- La <u>réflectance</u> ou le « coefficient de réflexion » : p= ($\phi_r/\phi_o$) avec $\phi_r$ correspondant au flux énergétique réfléchi sur la surface du matériau, et $\phi_0$ correspondant au flux énergétique incident apporté par le rayon incident. La réflectance $\rho$ correspond à la capacité d'un matériau à réfléchir une onde lumineuse incidente au matériau et peut notamment être influencée par son état de surface et sa rugosité.

Le principe de conservation du flux énergétique se traduit par l'équation suivante : $\Gamma + \alpha + \rho = 1$.

Pour un matériau, on peut également définir les termes suivants :

- L'<u>émissivité $\varepsilon$</u> :

  L'émissivité $\varepsilon$ d'un matériau traduit sa capacité à émettre un rayonnement par rapport à un corps noir dans les mêmes conditions de température et de longueur d'onde $\lambda$.
  Un corps noir est un corps émissif pour lequel l'absorbance $\alpha$ = 1 quelle que soit la longueur d'onde $\lambda$. A une température d'équilibre donnée et afin de conserver son équilibre thermique, le corps noir réémet toute la puissance qu'il reçoit. La puissance qu'il absorbe est alors égale à la puissance énergétique qu'il émet.

La loi de Kirchhoff précise que pour une température constante et pour une longueur d'onde donnée $\lambda$, l'émissivité $\varepsilon$ d'un matériau à l'équilibre thermique(en le comparant au corps noir de même température) est égale à l'absorbance ($\varepsilon = \alpha$).

Ainsi, pour une longueur d'onde $\lambda$ donnée, l'émissivité $\varepsilon$ peut être définie de la façon suivante : $\varepsilon = 1 - \Gamma - \rho$, et pour un corps opaque : $\varepsilon = 1 - \rho$.

- Un effet thermochrome : ceci correspond à la capacité du matériau, en fonction de sa température T, à présenter une variation réversible de ses propriétés optiques, notamment d'absorption, de transmission, de réflectance ou d'émission d'un rayon lumineux incident. On parle alors de matériau thermochrome ;

- « T » représentant la température interne moyenne du matériau ou du corps thermochrome pris en considération,

- « Tc » représentant la température critique de transition du matériau thermochrome considéré, c'est-à-dire la température à laquelle les propriétés électriques et optiques du matériau changent significativement, Tc pouvant être défini comme le maximum de la dérivée première de l'évolution du signal optique ou électrique en fonction de la température T. En d'autres termes, « Tc » correspond à la température « seuil » que va atteindre le matériau et au-delà de laquelle ses propriétés électriques et optiques intrinsèques changent.

- l'indice optique « n » : définit le rapport entre la vitesse d'une onde lumineuse dans le vide et la vitesse de propagation de l'onde considérée dans ledit matériau, « n » dépend de la température et de la nature du milieu et de la longueur d'onde $\lambda$.

En outre, dans le domaine des panneaux solaires thermiques permettant de chauffer un fluide caloporteur, on peut également définir la valeur de rendement initial « $\eta 0$ », c'est-à-dire la capacité du panneau à transformer l'énergie incidente issue des rayons lumineux du soleil en énergie thermique capable de chauffer un fluide caloporteur.

- « $\eta 0$ » est le produit entre la valeur d'absorbance du matériau absorbant considéré (généralement l'ensemble constitué par la feuille support en aluminium et la couche mince absorbante), de transmittance du verre du panneau, et d'un facteur F' rendant compte de la qualité du transfert thermique entre le matériau absorbant du panneau et le fluide caloporteur. Généralement le verre transmet au moins 91% des rayonnements incidents en provenance du soleil dont la longueur d'onde est comprise entre 250 et 2500nm, et F' = 0,94. Ainsi avec un matériau absorbant avec une absorbance des rayonnements incidents en provenance du soleil dont la longueur d'onde est comprise entre 250 et 2500nm de 0,94, le rendement initial $\eta 0$ est de 0,94 x 0,91 x 0,94=0,804

## Domaine technique de l'invention

L'invention concerne un matériau thermique, notamment de type absorbant, dont le rôle est de convertir l'énergie absorbée en énergie calorifique. Cette énergie calorifique est capable de donner de la chaleur qui est directement exploitable dans un réseau de chaleur, notamment de type eau chaude sanitaire.

L'invention concerne particulièrement un matériau multicouche auto-adaptatif, thermo régulé capable d'absorber des rayons lumineux définis par une certaine longueur d'onde $\lambda$, notamment comprise entre 250 et 2500 nm correspondant au spectre d'émission solaire.

Le matériau multicouche de l'invention est capable d'adapter ses propriétés électriques et optiques, notamment dans l'infrarouge, en fonction de la valeur de sa température interne.

Un tel dispositif trouvera une application particulière dans le domaine des panneaux solaires, en particulier les panneaux solaires thermiques.

## Etat de l'art

De manière connue, pour qu'un panneau solaire thermique soit efficace, il doit posséder une capacité d'absorption maximale de l'énergie issue des rayons lumineux, notamment des rayons solaires, tout en limitant au maximum la perte d'énergie par rayonnement thermique lorsque le panneau est chaud.

En fonctionnement normal, l'énergie issue des rayons solaires est convertie en chaleur par le panneau solaire. Cette chaleur est évacuée via un fluide caloporteur pour chauffer l'eau d'un réservoir, par exemple à l'aide d'un échangeur thermique.

Tant que le fluide caloporteur circule dans le panneau, la chaleur du panneau est évacuée et sa température reste en dessous de 100 à 120°C.

Lorsque l'eau du réservoir atteint la température souhaitée, nécessaire pour alimenter le réseau de chaleur, la circulation du fluide caloporteur est arrêtée. En conséquence, l'énergie emmagasinée par le panneau n'est plus évacuée alors que ledit panneau est toujours soumis aux rayons lumineux solaires. Dans ce cas, la température du panneau augmente jusqu'à une température d'équilibre dite « température de stagnation ». A la température de stagnation, le rendement initial n0 du panneau est nul. En d'autres termes, la « température de stagnation » peut être définie comme la différence de température à laquelle les gains en énergie issus des rayons lumineux en provenance du soleil ne peuvent compenser les pertes thermiques du panneau. Cette « température de stagnation » peut atteindre une valeur comprise entre 220 et 250°C pour un ensoleillement de 1000 W/m$^2$. Ainsi, en condition de stagnation, le panneau est incapable de dissiper la chaleur emmagasinée.

Une température de stagnation aussi élevée présente plusieurs inconvénients.

D'une part, elle entraine une dégradation accélérée du fluide caloporteur, habituellement garanti pour une température maximale d'utilisation de 170°C, ledit fluide caloporteur doit alors être périodiquement renouvelé. Par ailleurs, les températures de stagnation élevées, supérieures à 140°C pour une pression du fluide caloporteur d'environ 3 bars dans le panneau, favorisent les cycles de vaporisation/condensation du fluide caloporteur. Ces cycles sont accompagnés par des variations de pression importantes, notamment des variations de pression > 1 bar, qui peuvent générer des fuites au niveau des différentes connections hydrauliques.

D'autre part, une « température de stagnation » trop élevée entraine un risque de dégradation du matériau lui-même constituant ledit panneau solaire, ainsi qu'une perte de ses capacités d'absorption et une dégradation de ses propriétés optiques.

L'une des solutions proposées par la demande internationale WO 2014/140499 pour remédier à ce problème de température de stagnation du panneau consiste à utiliser un « matériau thermochrome » à base d'oxyde de vanadium VO$_2$ ou d'une combinaison d'oxydes de vanadium pour apporter de la chaleur au fluide caloporteur.

Ce matériau possède un « effet thermochrome » en fonction de sa température critique de transition « Tc ». En effet, pour une capacité d'absorbance identique :

- quand la température du matériau thermochrome à base d'oxyde de vanadium est inférieure à sa température critique de transition Tc, le matériau va avoir une absorbance supérieure à 0,75 pour les rayonnements de longueur d'onde comprise entre 0,4 et 2,5 pm. Le matériau va donc absorber et convertir partiellement le rayonnement issue du soleil en chaleur. Parallèlement, la transmittance de la couche sélective d'oxyde de vanadium supérieure à 0,85 dans l'infrarouge, permet d'obtenir un matériau avec une réflectance infrarouge élevée, c'est-à-dire avec une faible émissivité et présentant peu de pertes thermiques. Ces propriétés sont conditionnées, en outre, grâce au support, sur lequel repose la couche sélective d'oxyde de vanadium, qui est un bon réflecteur des infrarouges, c'est-à-dire présentant une réflectance supérieure à 0,8 pour les longueurs d'onde $\lambda$ supérieures à 5 $\mu$m. Ainsi, la majeure partie de la chaleur est transmisse au fluide caloporteur ;
- quand la température du matériau thermochrome à base d'oxyde de vanadium est supérieure à sa température critique de transition Tc, le matériau conserve une absorbance supérieure à 0,75 pour les rayonnements de longueur d'onde comprise entre 0,4 et 2,5$\mu$m. Le matériau continue à absorber et convertir partiellement le rayonnement issu du soleil en chaleur. Toutefois, la transmittance de la couche sélective d'oxyde de vanadium est réduite à des valeurs comprises entre 0,5 et 0,2, ce qui pour une absorbance constante de la couche sélective conduit à une réduction de la réflectance du matériau, c'est-à-dire à une émissivité élevée et à des pertes thermiques élevées. Ainsi, pour conserver le bilan énergétique, moins de chaleur est transmise au fluide caloporteur qui chauffe moins.

En conclusion, avec un matériau thermochrome à base de VO$_2$, l'émissivité infrarouge du matériau est variable en fonction de la température interne dudit matériau. Ainsi, en condition de stagnation, lorsque le matériau atteint sa température interne maximale, l'émissivité est élevée et l'énergie perdue par rayonnement thermique augmente, c'est-à-dire que la quantité d'énergie incidente arrivant vers le fluide caloporteur est diminuée. En conséquence, le fluide caloporteur se dégrade moins rapidement, car il est moins chauffé.

L'inconvénient du matériau thermochrome à base de VO$_2$ réside dans le fait que sa température de transition critique Tc est d'environ 68°C. Cette Tc n'est pas modifiable ou augmentable significativement sans altérer les propriétés électriques ou optiques du matériau, au détriment de ses propriétés thermochromes.

En d'autres termes, dans l'art antérieur, l'effet thermochrome du matériau est observé pour une température critique de transition Tc relativement faible. Cette température Tc de 68°C est atteinte assez rapidement en présence d'un rayonnement solaire intense (météo très ensoleillée) ce qui limite le rendement du panneau solaire lors de son fonctionnement. En effet, lorsque le matériau thermochrome à base de VO$_2$, constituant l'absorbeur ou capteur solaire d'un panneau solaire thermique, atteint la température de transition Tc de 68°C, le fluide caloporteur au niveau de l'échangeur d'un ballon d'accumulation d'eau chaude sanitaire par exemple n'est que de 55°C environ en raison de diverses pertes thermiques au niveau du système (raccords, longueurs des canalisations, ...) . Ainsi, pour une consigne de chauffe de l'eau sanitaire supérieure à 60°C dans le ballon d'accumulation et des pertes thermiques du système équivalentes, la température du matériau thermochrome devra être supérieure à 73°C. Or à cette température, les propriétés du matériau thermochrome à base de VO$_2$, c'est-à-dire de l'absorbeur ou capteur solaire thermochrome, sont transformées, il en résulte une augmentation des pertes thermiques et un rendement plus faible.

Idéalement une température critique Tc supérieure à 80°C est souhaitable pour une application solaire thermique sans perte de performance du panneau solaire.

C'est pourquoi, il est nécessaire de trouver une solution adéquate alternative au panneau solaire de l'art antérieur permettant de conserver, en condition de fonctionnement, un bon rendement énergétique du panneau solaire, tout en diminuant, en condition de stagnation, la valeur de la température de stagnation du matériau.

Il est à noter que la diminution de la valeur de la température de stagnation d'un matériau, utilisable en tant que panneau solaire, est une conséquence directe d'une augmentation de l'émissivité du matériau.

La présente invention a pour but de pallier les inconvénients de l'état de la technique, en proposant un matériau multicouche thermorégulé comprenant au moins :

- Un support ayant :

  • un coefficient de transmission $\Gamma$s sensiblement égal à 0, pour des rayonnements de longueur d'onde $\lambda$ compris entre 0,25 et 25 pm ;
  • un coefficient de réflexion $\rho$s $\geq$ 0,9, pour des rayonnements incidents de longueur d'onde $\lambda$ compris entre 7,5 et 10 pm ;

- et comprenant également au moins une couche thermorégulée d'épaisseur comprise entre 50 et 500 nm à base de pérovskites de cobaltites de terre rares ou de pérovskites de nickelates de terre rares ou de manganites de terre rares, ladite couche thermorégulée (2) surmontant une des surfaces dudit support.

Plus spécifiquement, ledit matériau multicouche thermorégulé a :

• pour des rayonnements de longueur d'onde $\lambda$ compris entre 0,25 et 2,5 pm ; un coefficient d'absorption $\alpha$m $\geq$ 0,8 ;
• et, pour des rayonnements incidents de longueur d'onde $\lambda$ compris entre 7,5 et 10 $\mu$m ; un coefficient de réflexion pm :

  *** $\geq$ 0,85, lorsque la température T dudit matériau multicouche est $\leq$ 100 °C ;
  *** compris entre 0,3 et 0,85, lorsque la température T dudit matériau multicouche est comprise entre 100 et 400°C.

De plus, selon une autre caractéristique de l'invention, lesdits pérovskites sont de formule ABO$_3$ :

• Avec « A » étant au moins un élément chimique unique ou un groupement d'élément chimique appartenant au groupe des terres rares ;
• Avec « B » étant soit du cobalt Co, soit du nickel Ni, soit du manganèse Mn et,
• Avec « O3 » représentant trois oxygènes.

En outre, selon d'autres caractéristiques de l'invention :

- « A » correspond à au moins un élément chimique appartenant à la famille des terre rares choisi parmi la liste suivante : le lanthane La ; le praséodyme Pr ; le néodyme Nd ; le samarium Sm ; le gadolinium Gd ou encore l'europium Eu ;
- avantageusement, ledit au moins un élément chimique « A » du perovskite de formule ABO$_3$ est dopé partiellement avec au moins un élément chimique « E » de fraction atomique « z » compris entre 0,1 et 0,6, ledit élément « E » appartenant au groupe des alcalinoterreux choisi parmi la liste suivante: le strontium Sr ; le calcium Ca ou le baryum Ba, de sorte que la couche thermorégulé soit de formule $A_{1-z}E_zCoO_3$ ou $A_{1-z}E_zNiO_3$ ou $A_{1-z}E_zMnO_3$ ;
- l'élément « B » du perovskite de formule ABO$_3$ est dopé partiellement avec au moins un élément chimique « D » de fraction atomique « y » compris entre 0,1 et 0,5 ; ledit élément « D » appartenant au groupe des métaux de transition choisi parmi la liste suivante : le cobalte Co ; le nickel Ni ; le manganèse Mn ; le fer Fe ; le titan Ti ; le vanadium V ou encore le chrome Cr, de sorte que la couche sélective thermorégulé soit de formule $ACO_{1-y}D_yO_3$ ou $ANi_{1-y}D_yO_3$ ou $AMn_{1-y}D_yO_3$ ;
- de manière avantageuse encore, les oxygènes «O$_3$» de la pérovskite de formule ABO3 sont dopés partiellement avec de l'azote N de fraction atomique « x » compris entre 0,03 et 1, de sorte que la couche thermorégulée soit de formule $ACoO_{3-x}N_x$ ou $ANiO_{3-x}N_x$ ou $AMn_{3-x}N_x$.

De préférence, la couche thermorégulée de formule ABO3, comprenant au moins l'un de ces éléments « A », « B » ou « O$_3$ » dopé partiellement :

- est d'épaisseur comprise entre 300 et 500 nm et,
- présente, pour des rayonnements incidents de longueur d'onde $\lambda$ compris entre 7,5 et 10 pm, un coefficient de transmission $\Gamma T$ :

        *** $\geq$ 0,95 pour une température interne de ladite couche thermorégulée inférieure ou égale à 100°C ;

        *** $\leq$ 0,6 pour une température interne de ladite couche thermorégulée comprise entre 100 et 200°C.

Selon un mode de réalisation particulier, ledit support consiste en une feuille métallique à base d'aluminium Al ou de cuivre Cu.

Selon un autre mode de réalisation préférentiel, ladite couche thermorégulée est recouverte d'une couche antireflet.

Selon un autre mode de réalisation de l'invention, ledit matériau comprend une couche barrière aptes à empêcher la diffusion à l'état solide d'éléments chimique du support vers la couche thermorégulée, ladite couche barrière étant positionnée entre ledit support et ladite couche thermorégulée.

Selon un mode de réalisation préférentielle de l'invention, ledit matériau multicouche thermorégulé de l'invention a :

- pour des rayonnements de longueur d'onde $\lambda$ compris entre 0,25 et 2,5 pm ; un coefficient d'absorption $\alpha m \geq 0,94$;
- et, pour des rayonnements incidents de longueur d'onde $\lambda$ compris entre 7,5 et 10 $\mu$m ; un coefficient de réflexion pm :

        *** $\geq$ 0,92, lorsque la température T dudit matériau multicouche (M) est $\leq$ 100 °C ;

        *** $\leq$ 0,6 ; lorsque la température dudit matériau multicouche est $\geq$ 100°C.

La présente invention concerne également un procédé de fabrication d'un matériau multicouche de l'invention dans lequel:

- On dépose sur ledit support par copulvérisation sous vide, en présence d'un plasma réactif d'argon et d'oxygène ou d'argon pur, une couche thermorégulée de formule générale $ABO_3$ avec « A » étant au moins un élément chimique unique ou un groupement d'éléments chimiques appartenant au groupe des terres rares et « B » un métal de transition de type Ni, Mn ou Co,
- On recuit ex situ le matériau obtenu précédemment à des températures comprises entre 525 et 800°C, de préférence 575 et 600°C pendant une durée comprise entre 30 secondes et 1 heure, de préférence entre 30 et 240 secondes.

La présente invention concerne également un panneau solaire comprenant un matériau multicouche thermorégulé selon l'invention.

Description de l'invention

D'autres caractéristiques et avantages de l'invention ressortiront de la description détaillée qui va suivre des modes de réalisation non limitatifs de l'invention, en référence aux figures annexées, dans lesquelles :

- la figure 1 représente schématiquement une vue d'un matériau multicouche thermorégulé de l'invention comprenant le support et la couche thermorégulée;
- la figure 2 représente graphiquement l'évolution de la réflectance $\rho_M$ d'un matériau multicouche thermorégulé, ayant un support en aluminium et une couche thermorégulée de la forme $LaCoO_3$, en fonction de la longueur d'onde $\lambda$ d'un rayon lumineux incident arrivant sur ledit matériau présentant une température T variable ;
- la figure 3 représente graphiquement l'évolution de la réflectance $\rho_s$ d'un support en fonction de la longueur d'onde $\lambda$ d'un rayon lumineux incident, ledit support étant constitué d'une feuille d'aluminium pure à 99,7% ; d'épaisseur 0,4 mm;
- la figure 4 représente graphiquement l'évolution de la réflectance $\rho_M$ d'un matériau multicouche thermorégulé de l'invention selon un autre mode de réalisation en fonction de la longueur d'onde $\lambda$ d'un rayon lumineux incident ;
- la figure 5 représente schématiquement le matériau multicouche thermorégulé de l'invention selon un mode particulier de réalisation comprenant une couche supplémentaire antireflet;
- la figure 6 représente schématiquement le matériau multicouche thermorégulé de l'invention selon un autre mode de réalisation particulier de l'invention comprenant une couche barrière;
- la figure 7 représente schématiquement le matériau multicouche thermorégulé de l'invention selon un mode supplémentaire de réalisation de l'invention comprenant à la fois une couche antireflet et une couche barrière.
- la figure 8 représente graphiquement l'évolution de l'émissivité d'un matériau multicouche de l'invention soumis à un rayon lumineux de longueur d'onde λ compris entre 7,5 et 14 pm, en fonction de sa température interne T°C, de la nature chimique et de l'épaisseur (200 ou 400 nm) de la couche thermorégulée dudit matériau.

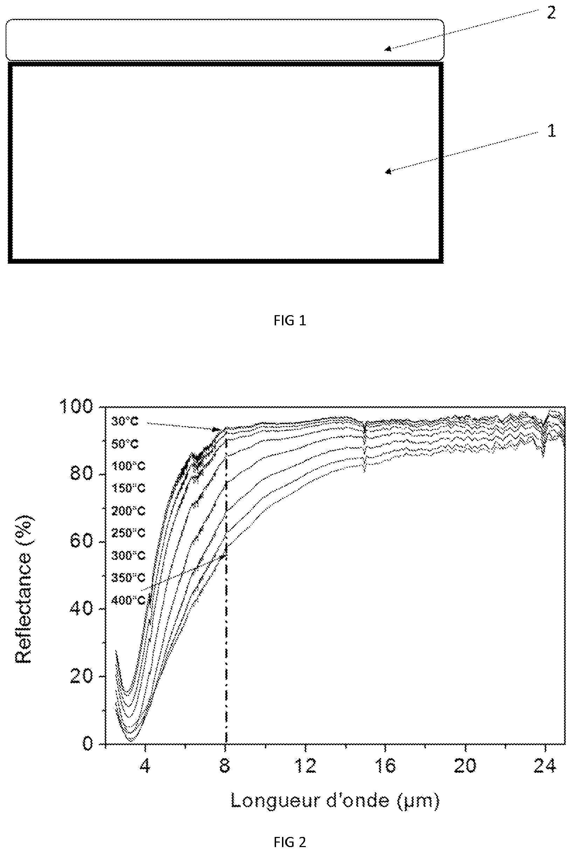

La présente invention concerne un matériau multicouche thermorégulé (M) tel que visible sur les figures 1, 5, 6 ou 7.

On entend par le terme « thermorégulé » la capacité du matériau à autoréguler sa température interne pour ne pas dépasser les 150°C, et de préférence rester entre 130 et 140°C. Ainsi, si ledit matériau thermorégulé est utilisé en tant que panneau solaire thermique pour chauffer un fluide caloporteur, le fait de ne pas dépasser les 150°C permet d'éviter la vaporisation du fluide caloporteur dans le panneau solaire thermique pour une pression interne de l'ordre de 3 bars, lorsqu'il est soumis à un rayon lumineux incident constitué d'ondes lumineuses de longueur d'onde λ comprise entre 0,25 et 2,5 μm.

Plus spécifiquement, l'autorégulation de la température interne T du matériau M est possible grâce à la modification de ses propriétés optiques, générant ou non une forte perte thermique.

Selon l'invention, ledit matériau multicouche thermorégulé M comprend au moins un support 1 surmonté d'au moins une couche thermorégulée 2. De manière optionnelle, ledit matériau M peut également comprendre, en plus, une couche antireflet 3 et/ou une couche barrière 4.

Selon l'invention, ledit support 1 est dans une matière possédant, quelle que soit la température interne dudit support:

- un coefficient de transmission $\Gamma_s$ égal ou sensiblement égal à 0, pour des rayonnements de longueur d'onde λ compris entre 0,25 et 25 pm ;
- un coefficient de réflexion $\rho s \geq 0,9$, pour des rayonnements incidents de longueur d'onde λ compris entre 7,5 et 10 pm.

Ledit support 1 est constitué par un matériau métallique résistant mécaniquement à des températures comprises entre 50 et 600°C.

Selon un mode de réalisation particulier, ledit support 1 consiste en une feuille métallique à base d'aluminium Al ou de cuivre Cu d'épaisseur comprise entre 0,1 et 2 mm. Ledit support 1 présentant un état de surface adéquat, notamment une rugosité, lui permettant d'atteindre la valeur du coefficient de réflexion susmentionné, pour des rayonnements infrarouges.

L'épaisseur faible du support 1 a pour avantage de diminuer les frais de fabrication dudit support 1 à échelle industrielle tant que la résistance mécanique, notamment à haute température, est conservée.

Selon un autre mode de réalisation particulier, le support 1 est constitué d'une feuille métallique constituée à 99,7% d'aluminium Al, d'épaisseur égale à 0,4 mm, présentant une résistance mécanique à la traction $R_M \geq$ à 160 MPa à la température ambiante.

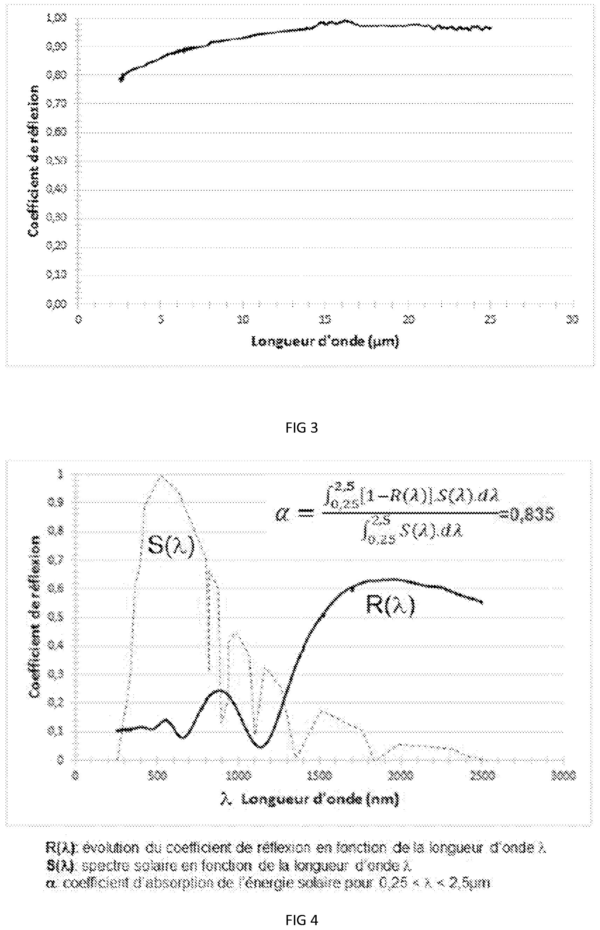

Tel qu'illustré sur la figure 3, ce support 1 particulier présente avantageusement un coefficient de réflexion ρs ≥ 0,9 pour des rayons incidents de longueur d'onde λ compris entre 7,5 et 10 pm, soit une capacité à réfléchir 90% de l'énergie incidente arrivant à son contact.

Selon un autre mode de réalisation moins couteux, ledit support 1 est constitué d'un matériau métallique quelconque, résistant mécaniquement à la traction et à des températures pouvant atteindre jusqu'à 600°C, et présentant une épaisseur comprise entre 0,1 et 2 mm.

Selon l'invention, ledit support 1 est surmonté d'une couche thermorégulée 2 qui apporte, en combinaison avec les caractéristiques dudit support 1, les propriétés optiques du matériau multicouche thermorégulé M de l'invention.

En d'autres termes, la couche thermorégulée 2 surmonte l'une des surfaces dudit support 1, et ainsi permet une interaction entre ledit support 1 et ladite couche 2 générant des propriétés optiques spécifiques sur tout le matériau multicouche thermorégulé M.

Dans tous les cas, pour la réalisation de l'invention, il est nécessaire que la couche thermorégulée 2 soit déposée sur un support 1 capable de réfléchir un rayonnement infrarouge.

Selon l'invention, ladite couche thermorégulée 2 présente une épaisseur comprise entre 50 et 500 nm, de préférence à base de pérovskites de cobaltites de terre rares ou de pérovskites de nickelates de terre rares ou de manganites de terre rares.

Selon une spécificité de l'invention, les pérovskites sont de formule $ABO_3$ :

- Avec « A » étant au moins un élément chimique unique ou un groupement d'éléments chimiques appartenant au groupe des terres rares;
- Avec « B » étant soit du cobalt Co, soit du nickel Ni, soit du manganèse Mn et,
- Avec « $O_3$ » représentant trois atomes oxygènes.

Les terres rares consistent en un groupe de 17 métaux aux propriétés électromagnétiques et chimiques voisines.

Avantageusement, les pérovskites présentent en tant qu'élément « A », un élément correspondant à au moins un élément chimique appartenant à la famille des terres rares, de préférence choisi parmi la liste suivante : le lanthane La ; le praséodyme Pr ; le néodyme Nd ; le samarium Sm ; le gadolinium Gd ou encore l'europium Eu.

En d'autres termes, « A » peut être constituée par un ou plusieurs élément(s) chimique(s) de type terre rare susmentionné.

Selon un mode privilégié de réalisation de l'invention, l'élément « A » consiste en du lanthane La.

Selon un mode de réalisation particulier de l'invention, ledit au moins élément chimique « A » du pérovskite de formule $ABO_3$ est dopé partiellement avec au moins un élément chimique « E » de fraction atomique z compris entre 0,1 et 0,6, ledit élément « E » appartenant au groupe des alcalinoterreux choisi parmi la liste suivante : le strontium Sr ; le calcium Ca ou le baryum Ba, de sorte que la couche sélective thermorégulé (2) soit de formule $A_{1-z}E_zCoO_3$ ou $A_{1-z}E_zNiO_3$ ou $A_{1-z}E_zMnO_3$.

Selon un autre mode particulier de réalisation de l'invention, lesdits pérovskites présentent en tant qu'élément « B » du cobalt Co, du nickel Ni ou du manganèse Mn, ledit élément « B » étant dopé partiellement avec au moins un élément chimique « D » de fraction atomique y compris entre 0,1 et 0,5 ; ledit élément « D » appartenant au groupe des métaux de transition choisi parmi la liste suivante : le cobalte Co ; le nickel Ni ; le manganèse Mn ; le fer Fe ; le titane Ti ; le vanadium V ou encore le chrome Cr, de sorte que la couche sélective thermorégulé (2) soit de formule $ACO_{1-y}D_yO_3$ ou $ANi_{1-y}D_yO_3$ ou $AMn_{1-y}D_yO_3$.

Selon un mode de réalisation préférentiel, on utilisera comme couche thermorégulée 2 un composé de la famille des manganites de formule $AMnO_3$ dopé avec du baryum Ba. Ce dernier présente comme avantage d'augmenter l'émissivité $\varepsilon_M$ du matériau multicouche M dans une gamme de température autour de 100°C.

En d'autres termes, pour une gamme de température comprise entre 20°C et 100 °C, l'émissivité $\varepsilon_M$ du matériau multicouche M de l'invention va varier entre 0,5 et 0,65 si la couche thermorégulé 2, recouvrant un support 1 en aluminium, est à base de manganite dopé au baryum.

Selon un mode supplémentaire de réalisation de l'invention, les perovskites de formule $ABO_3$ sont dopés partiellement au niveau de leur site anionique « $O_3$ » avec de l'azote N de fraction atomique x compris entre 0,03 et 1, de sorte que la couche sélective thermorégulé (2) soit de formule $ACoO_{3-x}N_x$ ou $ANiO_{3-x}N_x$ ou $AMn_{3-x}N_x$.

De manière avantageuse, la couche thermorégulée 2 de formule $ABO_3$, comprend au moins l'un de ces éléments « A », « B » ou « $O_3$ » dopé partiellement tel que susmentionné.

Ainsi, les différents dopages possibles de la couche thermorégulée 2 permettent de modifier les propriétés optiques et électriques du matériau multicouche M et de moduler sa température critique de transition Tc pour son effet thermochrome.

Pour ces propriétés optiques spécifiques, ce matériau M de l'invention est tout à fait propice à être utilisé en tant que panneau solaire dans des résidences domestiques ou collectives. En particulier, ledit matériau M peut être utilisé en tant que panneau solaire thermique destiné à chauffer un fluide caloporteur alimentant un réseau de chaleur domestique ou industriel.

Selon un mode préféré de réalisation de l'invention, le matériau multicouche thermorégulé M comporte une couche thermorégulée 2 d'épaisseur comprise entre 300 et 500 nm de formule $ABO_3$, comprenant au moins l'un de ces éléments « A », « B » et «O3» dopés partiellement ou non, et présente, pour des rayonnements incidents de longueur d'onde $\lambda$ compris entre 7,5 et 10 pm, un coefficient de transmission $\Gamma_T$ :

*** $\geq$ 0,95 pour une température interne de ladite couche thermorégulée (2) $\leq$ 100°C ;

*** $\leq$ 0,6 pour une température interne de ladite couche thermorégulée (2) comprise entre 100 et 200°C.

Grâce aux propriétés optiques respectives du support 1 et de la couche thermorégulée 2 et de l'interaction entre les deux, le matériau multicouche M de l'invention possède des propriétés optiques globales spécifiques avantageuses qui résultent de la combinaison et de la superposition des deux. En effet, le matériau multicouche M possède, pour des rayonnements de longueur d'onde $\lambda$ compris entre 0,25 et 2,5 $\mu$m, un coefficient d'absorption $\alpha$m $\geq$ 0,8 quelle que soit la température du support 1 surmonté de sa couche 2.

Ainsi, le matériau multicouche M de l'invention est capable d'absorber au moins 80% de l'énergie provenant d'un rayon lumineux incident de longueur d'onde $\lambda$ comprise entre 0,25 et 2,5 $\mu$m audit matériau M.

Selon une spécificité de l'invention, ledit matériau multicouche M présente, pour des rayonnements incidents de longueur d'onde $\lambda$ comprise entre 7,5 et 10 $\mu$m; un coefficient de réflexion $\rho$m :

*** $\geq$ 0,85, lorsque la température T dudit matériau multicouche (M) est $\leq$ 100 °C ;

*** compris entre 0,3 et 0,85, lorsque la température T dudit matériau multicouche (M) est comprise entre 100 et 400°C. Plus particulièrement, ledit matériau multicouche M présente, pour des rayonnements incidents de longueur d'onde $\lambda$ comprise entre 7,5 et 10 pm; un coefficient de réflexion pm ;

*** $\geq$ 0,85, lorsque la température T dudit matériau multicouche (M) est $\leq$ à une température critique Tc comprise entre 80 °C et 120°C;
*** compris entre 0,3 et 0,85, lorsque la température T dudit matériau multicouche est comprise entre 100 et 400°C, de préférence entre 100 et 150°C, préférentiellement encore entre 80 et 100°C.

Plus spécifiquement, le matériau multicouche thermorégulé M de l'invention possède avantageusement :

- pour des rayonnements de longueur d'onde $\lambda$ comprise entre 0,25 et 2,5 pm quelle que soit la température; un coefficient d'absorption $\alpha_m \geq$ 0,94 ;
- et, pour des rayonnements incidents de longueur d'onde $\lambda$ comprise entre 7,5 et 10 $\mu$m ; un coefficient de réflexion $\rho_m$ :

    *** $\geq$ 0,92, lorsque la température dudit matériau multicouche (M) est $\leq$ 100 °C ;
    *** $\leq$ 0,6 ; lorsque la température dudit matériau multicouche est $\geq$ 100°C.

Dans la suite de la description, on désignera par « T » la température interne moyenne du matériau multicouche M.

De la même manière, on désignera par « Tc » la température critique correspondant à la température à laquelle le matériau multicouche M, plus particulièrement la couche thermorégulée 2 modifie ses propriétés optiques et électriques.

Comportement du matériau multicouche de l'invention en fonction de sa température T

Pour le matériau multicouche M de l'invention, Tc étant compris entre 80 et 120°C, la demanderesse a étudié le comportement du matériau multicouche M de l'invention et les modifications de ses propriétés optiques et électriques.

Fonctionnement si T < Tc

Dans cette configuration, la couche thermorégulée 2 de l'invention présente une structure cristallographique stable générant un comportement semi-conducteur.

Dans ces conditions de température, pour des rayonnements incidents de longueur d'onde $\lambda$ comprise entre 7,5 et 10 $\mu$m:

- le support 1 présente un fort pouvoir de réflexion $\rho$s $\geq$ 0,9 ; et un coefficient de transmission $\Gamma$s, sensiblement égal à 0, proche de 0 ou égal à 0, ce qui le rend opaque ;
- la couche thermorégulée 2 possède un comportement de type semi-conducteur, d'où une valeur de transmittance $\Gamma_T \geq$ 0,8 donc présente une forte transparence,
- il en résulte que le matériau multicouche M présente dans ces conditions, une émissivité $\varepsilon$m $\leq$ à 0,15.

En conséquence, quand T < Tc, le matériau multicouche M n'émettra que 15% de l'énergie possible à cette température. En d'autres termes, pour des rayonnements incidents de longueurs d'onde $\lambda$ comprises entre 0,25 et 2,5 $\mu$m, quand T < Tc les pertes thermiques par émission infrarouge limitées à 15% permettent un rendement optimal de fonctionnement d'un panneau solaire thermique, équipé du matériau M, pour chauffer un fluide caloporteur, ce dernier alimentant par exemple une eau sanitaire dans un réseau d'installation domestique.

Fonctionnement si T > Tc

Dans cette configuration, la couche thermorégulée 2 de l'invention présente une structure cristallographique stable générant un comportement semi-métallique ou métallique.

Dans ces conditions de température, pour des rayonnements incidents de longueur d'onde $\lambda$ comprise entre 7,5 et 10 $\mu$m:

- le support 1 présente un fort pouvoir de réflexion, c'est-à-dire un coefficient de réflexion $\rho$s $\geq$ 0,9; et un coefficient de transmission $\Gamma$s sensiblement égale à 0, proche de 0 ou égale à 0, ce qui le rend opaque,
- la couche thermorégulée 2 possède un coefficient de transmission $\Gamma_T$ < 0,9, idéalement < 0,6 ;
- il en résulte que le matériau multicouche M, présentant pour une longueur d'onde infrarouge $\lambda$ comprise entre 7,5 et 10 $\mu$m, un coefficient de réflexion $\rho_M$ compris entre 0,85 et 0,3, idéalement entre 0,6 et 0,3 ; et aura une émissivité $\varepsilon$m comprise entre 0,15 et 0,7, idéalement entre 0,4 et 0,7.

En conséquence, quand T > Tc, le matériau multicouche M émettra entre 15% et 70%, idéalement entre 40% et 70% de l'énergie possible à la température T.

En d'autres termes, pour des rayonnements incidents de longueur d'onde λ comprise entre 0,25 et 2,5 μm, quand T > Tc, les pertes thermiques par émission infrarouge sont supérieures à 15%, et idéalement supérieures à 40%.

Ainsi, dans le cas où le matériau M de l'invention équipe un panneau solaire thermique chauffant un fluide caloporteur alimentant un réseau de chaleur, dans ces conditions où T > Tc, l'énergie transmise du panneau au fluide caloporteur est réduite et la température de stagnation du panneau est diminuée.

Ainsi, le matériau de l'invention, en fonction de la valeur de sa température T par rapport à sa température Tc possède des propriétés d'émission infrarouge qui changent. La modification d'émission infrarouge influence et contrôle le niveau des pertes thermiques dudit matériau M et en fait un candidat privilégié pour une utilisation en tant que panneau solaire thermique destiné à chauffer un fluide caloporteur alimentant un réseau de chaleur.

D'après des résultats d'expérience, un panneau solaire réalisé avec le matériau multicouche M de l'invention soumis à un rayonnement issue du soleil d'énergie égale à 1000W/m$^2$ :

- met en évidence un rendement initial η0 de fonctionnement > à 80%,
- permet de réduire la température de stagnation d'une valeur équivalente à la variation d'émissivité Δε infrarouge (exprimée en pourcent) observée lorsque la température du matériau M augmente d'une valeur T < Tc à une valeur $T_1$ > Tc.

Ainsi, pour une variation d'émissivité Δε infrarouge de 5% à 50%, par exemple, la température de stagnation d'un panneau solaire réalisé avec le matériau multicouche M de l'invention sera diminuée de 45°C environ par rapport à un panneau solaire thermique traditionnel présentant le même rendement initial η0 et présentant une émissivité infrarouge εm équivalente à celle du matériau M à T < Tc (0,05 dans cet exemple).

Dans ces conditions, si la température de stagnation du panneau ou capteur solaire thermique traditionnel est de 190°C, la température de stagnation d'un panneau solaire réalisé avec le matériau multicouche M de l'invention sera de 145°C seulement.

Ainsi, grâce à l'invention, un panneau solaire utilisant le matériau multicouche M sera pérenne dans le temps, se dégradera beaucoup plus lentement que les panneaux de l'art antérieur car la température de stagnation est plus faible, et permettra la protection de l'ensemble du système et de l'installation thermique.

En plus, la diminution de la température de stagnation du panneau solaire sera un gain économique aussi bien en matière de renouvellement du fluide caloporteur dont la température n'excédera plus la valeur limite de 170°C (fluide garanti à vie), qu'en nécessité d'avoir des installations spécifiques résistantes à des températures supérieures à 150°C.

Ainsi, la présente invention concerne également un panneau solaire comprenant un matériau multicouche M thermorégulé de l'invention.

Variante de réalisation et amélioration

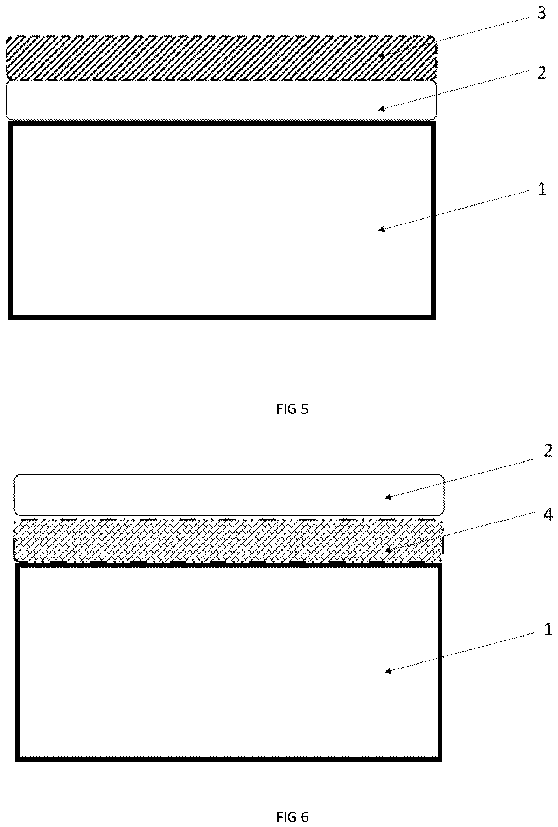

En plus des dopages possibles de la couche thermorégulée 2, les propriétés optiques du matériau multicouche M peuvent encore être modifiées et améliorées, notamment par l'ajout d'une couche antireflet 3 et/ou d'une couche barrière 4 tel que visible sur les figures 5 à 7.

Tel que visible sur la figure 5, la couche antireflet 3 est apposée directement au-dessus de la couche thermorégulée 2, elle permet de la protéger en plus d'assurer son effet d'antireflet.

Selon l'invention, ladite couche antireflet 3, qui recouvre ladite couche thermorégulée 2, peut se présenter sous la forme $SiO_2$, $Si_3N_4$, $Al_2O_3$ ou encore AlN ou $TiO_2$, ou une association de ces différents matériaux, $TiO_2$/$SiO_2$ par exemple.

Selon un mode particulier de réalisation, afin d'augmenter le coefficient d'absorption αm du matériau multicouche M à des valeurs > 0,9, pour des rayonnements de longueur d'onde λ compris entre 0,25 et 2,5 pm, ladite couche antireflet 3 présente avantageusement un indice optique n < 2,8 et une épaisseur comprise entre 50 et 150 nm.

De manière générale, il est nécessaire que l'indice optique n de la couche antireflet 3 soit inférieur à l'indice optique n de la couche thermorégulée 2.

Avantageusement, l'indice optique n de la couche thermorégulée 2 est égal à la racine carré de l'indice optique n de la couche antireflet 3.

L'intensité maximale des rayons lumineux issus du soleil se trouvant pour des longueurs d'ondes λ comprises entre 550 et 600 mm; afin d'obtenir l'effet antireflet 3 maximal, il a été constaté que l'épaisseur « e » en nm de la couche antireflet 3 doit respecter la relation suivante :

$$E_{nm} = (λ / (4.n)) = (550 \text{ à } 600 / (4.n)).$$

Par exemple, pour un matériau multicouche M, comprenant :

- une couche thermorégulée 2 de LaCoCO$_3$ ou de LaCoO$_{3-x}$N$_x$,
- une couche antireflet 3 à base de SiO$_2$ d'épaisseur « e » égale à 90 nm, d'indice optique « n » compris entre 1,48 et 1,5 ; le coefficient d'absorption $\alpha$m du matériau multicouche M sera > 0,94, ceci pour des rayonnements de longueur d'onde $\lambda$ compris entre 0,25 et 2,5 $\mu$m.

Dans cet exemple, la présence de la couche antireflet 3 a permis d'augmenter le coefficient d'absorption $\alpha$m de 0,04% par rapport au même matériau multicouche M dépourvu de ladite couche 3.

De manière avantageuse, tel que visible sur la figure 6, le matériau multicouche M peut également comprendre une couche barrière 4 située entre le support 1 et la couche thermorégulée 2.

Ladite couche barrière 4 présente de préférence une épaisseur comprise entre 10 et 100 nm, ainsi qu'une microstructure compacte sans porosité pour assurer son rôle de barrière de diffusion.

Ladite couche barrière 4 peut être constituée d'oxyde, de nitrure ou encore d'oxy-nitrure de métaux tels que le chrome Cr, le titane Ti, le vanadium V, le niobium Nb, l'aluminium Al, le silicium Si ou encore le zirconium Zr.

Le rôle de la couche barrière 4 est d'éviter une diffusion à l'état solide d'éléments chimiques du support 1 vers la couche thermorégulée 2, lors du procédé de fabrication du matériau multicouche M de l'invention, cette diffusion pouvant nuire aux propriétés optiques dudit matériau M.

Plus spécifiquement, la couche barrière 4 permet d'éviter cette diffusion lors du recuit de cristallisation rapide à haute température, par exemple à des températures $\geq$ à 550°C.

## Procédé de fabrication du matériau multicouche M

Le matériau multicouche M de l'invention peut être fabriqué en réalisant les étapes suivantes :

- On dépose sur ledit support (1) par copulvérisation sous vide, en présence d'un plasma d'argon et d'oxygène, une couche thermorégulée 2 de formule générale ABO$_3$ avec « A » étant au moins un élément chimique unique ou un groupement d'éléments chimiques appartenant au groupe des terres rares et B un métal de transition de type Ni, Mn ou Co,
- On recuit ex situ le matériau obtenu précédemment à des températures comprises entre 525 et 800°C, de préférence 575 et 600°C pendant une durée comprise entre 30 secondes et 1 heure, de préférence entre 30 et 240 secondes.

Le ratio des puissances appliquées aux cibles « A » et au cobalt Co ou au nickel Ni, ou de manganèse Mn défini la composition chimique de ladite couche thermorégulée 2.

De la même manière, le ratio des débits d'argon et d'oxygène définit le taux d'oxydation de la couche thermorégulée 2.

Avantageusement, un débit d'argon excédentaire à celui de l'oxygène avec un ratio de 3 pour 1 est privilégié pendant l'acte de dépôt afin d'avoir une couche thermorégulée 2 avec un oxyde stable ; c'est-à-dire un état parfaitement oxydée.

Dans ce procédé de fabrication, la morphologie, la densité et la structure de la couche thermorégulée 2 sont déterminées par la pression de travail en Pa. La pression de travail en Pa est définie par les débits d'argon et d'oxygène introduits, ainsi que par la vitesse de pompage du système.

Selon l'invention, pour obtenir une couche thermorégulée 2 de morphologie compacte, c'est-à-dire sans morphologie colonnaire et présentant les propriétés optiques de l'invention, la pression de travail est de préférence comprise entre 0,1 et 0,5 Pa et la distance séparant les cibles du substrat/support est comprise entre 5 et 10 cm.

Suite à la première étape de co-pulvérisation à température ambiante, la couche thermorégulée 2 est amorphe et ne présente pas d'effet thermochrome.

Afin d'obtenir une structure au moins partiellement cristallisée de type pérovskite et l'acquisition des propriétés thermochrome du matériau multicouche M de l'invention, le support 1 peut être maintenu in-situ à une température comprise entre 525 et 800°C, ou le matériau multicouche M peut être recuit ex-situ à postériori entre 525 et 800°C, comme décrit précédemment.

Selon un autre mode de réalisation, la couche thermorégulée 2 peut également être formée en deux étapes successives, à savoir :

a) On dépose les différents constituants de la couche thermorégulée 2 sous vide par copulvérisation en présence d'argon uniquement,

b) On recuit à une température > à 500°C et à la pression atmosphérique sous air.

Dans ce mode de réalisation d'oxydation/cristallisation à pression atmosphérique, l'oxygène naturellement présent dans l'air, avec une pression partielle homogène, diffuse à l'état solide dans la couche thermorégulée 2 en cours de cristallisation et forme ainsi la structure pérovskite désirée du matériau multicouche M.

Ce second mode de réalisation est avantageux à échelle industrielle car un gain de temps est réalisé. En effet, en absence d'oxygène, la vitesse de dépôt des constituants de la couche thermorégulée 2 est divisée par cinq.

Ainsi, le matériau multicouche M de l'invention à base de pérovskites a pour avantage de présenter une température critique de transition Tc de l'ordre de 100°C, ce qui est plus élevé que les 68-80°C de l'art antérieur. L'effet thermochrome se réalise à une température plus élevée.

En outre, cette température de transition Tc supérieure ou égale à 100°C permet d'éviter des erreurs d'interprétation de la courbe de rendement d'un panneau solaire constitué dudit matériau M de l'invention.

En effet, l'efficacité de rendement d'un panneau solaire est déterminée par un test de normalisation en usage dans l'Union Européenne. Ce test de normalisation consiste à mesurer l'efficacité de rendement d'un panneau solaire en traçant la courbe de rendement en fonction de la température moyenne interne du panneau, ceci lorsqu'on impose la température du fluide caloporteur d'entrée « T°in » et que l'on mesure la température dudit fluide chauffé « T°out » en sortie dudit panneau, ceci pour l'exposition dudit panneau à un rayonnement d'énergie constante. Dans ce test de normalisation, un point de mesure à 75°C est pris.

Dans l'art antérieur, l'effet thermochrome se réalise autour de 60°C mais sur une plage de température allant de 55 à 80°C. Ceci pose un problème si l'on prend comme température moyenne de référence du fluide 50°C pour le calcul du rendement. En effet, la valeur de la Tc étant proche des 50°C moyen du fluide, à cette température de 60°C, le panneau a déjà commencé légèrement à se transformer et a démarré son effet thermochrome, d'où une erreur d'interprétation de la courbe de rendement. Ainsi, avec le matériau multicouche de l'art antérieur, présentant une couche sélective de VO$_2$ présentant une température critique de transition Tc de 68°C, un point de mesure à 75°C, pénalise et falsifie les résultats du test de normalisation.

Au contraire, avec un panneau solaire constitué d'un matériau multicouche de l'invention, la Tc étant élevée et d'une valeur éloignée des 50°C du fluide, il n'y a plus d'erreur possible dans l'interprétation de la courbe de rendement, même en prenant un point de mesure à 75°C.

Les exemples ci-dessous permettent d'illustrer la présente invention et donnent des modes de réalisation particuliers du matériau multicouche M de l'invention.

Exemple 1

En réalisant le procédé de l'invention, on fabrique dans une enceinte de laboratoire un matériau multicouche M dont la couche thermorégulée 2 est à base de cobaltite de lanthane de formule LaCoO$_3$.

Pour faire ce matériau M, on utilise comme support 1 une feuille en aluminium de 0,4 mm d'épaisseur sur laquelle on copulvérise les constituants de la couche thermorégulée 2.

Le tableau 1 ci-dessous donne les paramètres de dépôt utilisés pour la synthèse de la couche thermorégulée 2 par copulvérisation sous vide.

Tableau 1

| Paramètre de dépôt | Valeur |
|---|---|
| Pression de travail (Pa) | 0,5 |
| Débit d'argon (Ncm$^3$.min$^{-1}$) | 21 |
| Débit d'oxygène (Ncm$^3$.min$^{-1}$) | 7 |
| Densité de puissance cible La (W.cm$^{-2}$) | 5,4 à 5,5 |
| Densité de puissance cible Co (W.cm$^{-2}$) | 2,5 à 2,6 |
| Distance cible La - substrat (mm) | 55 |
| Distance cible La - substrat Co (mm) | 70 |

Dans le tableau 1 ci-dessus, le terme « substrat » définit le matériau qui sera utilisé pour servir de support. Avantageusement, le substrat consiste en de l'aluminium, servant à faire le support 1 pour la couche thermochrome 2.

Après dépôt sous vide, un recuit rapide compris entre 525°C et 800°C de 30 secondes à 1 heure permet de cristalliser la couche thermorégulée 2 de LaCoO$_3$ afin qu'elle acquiert son effet thermochrome.

La température de recuit rapide est dans ce cas de 140°C plus élevée que la température de fusion du support 1 en aluminium, ainsi la durée du recuit de 30 secondes a pour avantage de conserver l'intégrité du support 1.

La figure 2 montre pour le matériau multicouche M de cet exemple 1 une variation du coefficient de réflexion $\rho_m$ dudit matériau M en fonction :

EP 3 596 408 B1

- de sa température interne variant entre 30 et 400°C et,
- de la longueur d'onde λ du rayon incident arrivant sur ledit matériau M.

La figure 2 met en évidence l'effet thermochrome du matériau M qui est visible pour des longueurs d'ondes λ comprise entre 7,5 et 10 pm et des températures internes dudit matériau M de $LaCoO_3$ comprises entre 30 et 400°C.

Ainsi, pour un rayon incident infrarouge de longueur d'onde λ de 7,5 $\mu$m, le coefficient de réflexion pm évolue de 0,92 à 0,52 lorsque la température dudit matériau M augmente de 30 à 400°C. Ceci consiste en l'effet thermochrome et correspond également à une augmentation de l'émissivité ε à 7,5 pm de 0,08 à 0,48 pour une température dudit matériau M qui augmente de 30 à 400°C.

Ledit matériau M à base de $LaCoO_3$ présente toutes les caractéristiques et propriétés optiques adéquates pour servir de matériau de base pour un panneau solaire alimentant en énergie, notamment de type thermique, un réseau de distribution domestique.

Exemple 2

En réalisant le procédé de l'invention, on fabrique dans une enceinte de laboratoire un matériau multicouche M dont la couche thermorégulée 2 est à base de cobaltite de lanthane dopée à l'azote de formule $LaCoO_{2,94}N_{0,06}$.

Pour faire le matériau multicouche M de l'exemple 2, on utilise comme support 1 une feuille en aluminium pure à 99,7%, de 0,4 mm d'épaisseur, présentant un coefficient de réflectance ≥ 0,9.

La figure 3 montre l'évolution du coefficient de réflexion $\rho_s$ dudit support 1 en fonction de la longueur d'onde λ d'un rayon incident. On constate qu'avec ledit support 1, pour des rayons incidents de longueur d'onde λ compris entre 7,5 et 10 $\mu$m, le coefficient de réflexion $\rho_s$ du support 1 est > à 0,9, il possède donc une grande capacité à réfléchir l'énergie des rayons incidents.

Pour le dopage à l'azote de la couche thermorégulée 2, l'azote est ajouté dans le plasma argon oxygène et définira la fraction d'atome d'azote x dans la couche thermorégulée 2. Dans cet exemple, l'azote ajouté représente entre 1 et 33% du plasma argon-oxygène et définira donc une fraction atomique x comprise entre 0,03 et 1.

Le tableau 2 ci-dessous donne les paramètres de dépôt utilisés pour la synthèse de la couche thermorégulée 2, de 320 nm d'épaisseur, par co-pulvérisation sous vide.

Tableau 2

| Paramètre de dépôt | Valeur |
|---|---|
| Pression de travail (Pa) | 0,5 |
| Débit d'argon (Ncm$^3$.min$^{-1}$) | 21 |
| Débit d'oxygène (Ncm$^3$.min$^{-1}$) | 6 |
| Débit d'azote (Ncm3.min-1) | 1 |
| Densité de puissance cible La (W.cm$^{-2}$) | 5,4 à 5,5 |
| Densité de puissance cible Co (W.cm$^{-2}$) | 1,8 à 1,9 |
| Distance cible - substrat La (mm) | 50 |
| Distance cible - substrat Co (mm) | 70 |

Après dépôt sous vide, un recuit rapide inférieur ou égal à 1 heure permet de cristalliser la couche thermorégulée 2 de $LaCo\ O_{2,94}\ N_{0,06}$ afin que la matériau multicouche M acquiert un effet thermochrome associé à une augmentation de l'émissivité lorsque la température augmente.

Le matériau multicouche M de l'exemple 2 à base d'une couche thermorégulée 2 de $LaCo\ O_{2,94}\ N_{0,06}$ présente avantageusement les propriétés optiques suivantes :

- Pour des rayons lumineux de longueur d'onde compris entre 0,2 et 2,5 pm, tel que visible sur la figure 4, un coefficient d'absorption $\alpha_m$ de 0,835,
- Pour des rayons de longueurs d'onde compris entre 7,5 et 14 pm :

    *** pour une température dudit matériau M < à 100°C, une émissivité ε moyenne de 0,055
    *** pour une température dudit matériau M > à 100°C, une émissivité ε moyenne de 0,42.

Ainsi, le dopage à l'azote du matériau fabriqué dans l'exemple 2 permet de réduire la valeur de la température Tc à une valeur proche de 100°C ce qui rend ce matériau optimal pour une application en tant que panneau solaire thermique à usage domestique.

Ledit matériau M à base de $LaCoO_{2,94} N_{0,06}$ présente toutes les caractéristiques et les propriétés optiques adéquates pour servir de matériau de base pour un panneau solaire utilisable dans un réseau d'énergie thermique domestique.

Dans ces conditions, un panneau solaire thermique équipé dudit matériau multicouche de l'invention présente de nombreux avantages par rapport aux solutions existantes. En effet, la température critique Tc a été augmentée, par rapport à l'art antérieur et passe de 68°C à 100°C. En d'autres termes, l'effet thermochrome se réalise à une température critique Tc plus élevée que dans l'art antérieur.

En outre, la température de stagnation est également réduite d'une valeur qui correspond de 0,7 à 1 fois la variation d'émissivité $\Delta\varepsilon$ observé.

Exemple 3

Les caractéristiques optiques du matériau multicouche M sont fonction de son procédé de fabrication et des conditions de son élaboration, mais aussi de l'épaisseur de la couche thermorégulée 2.

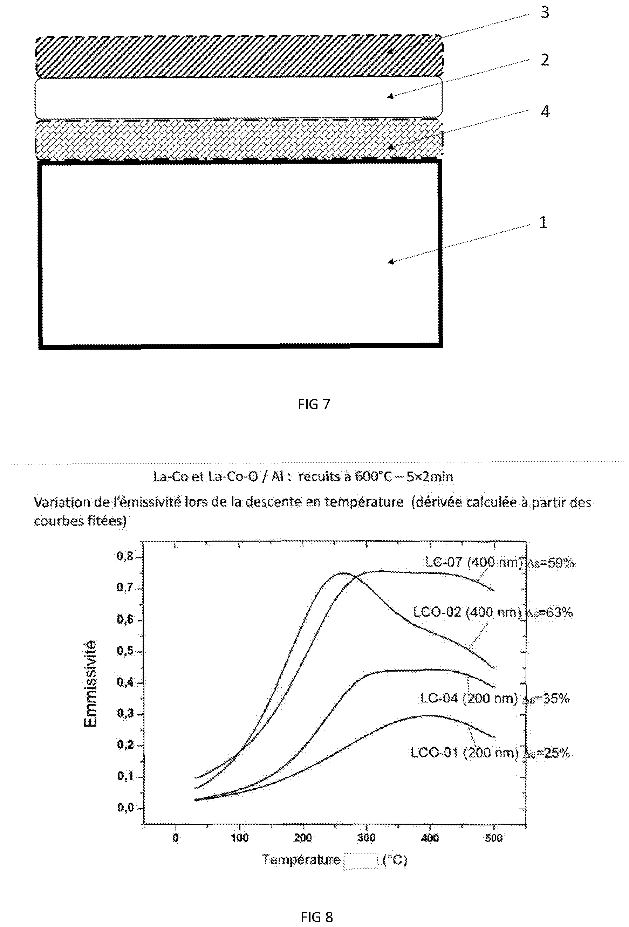

La figure 8 montre l'évolution de l'émissivité $\varepsilon$ d'un matériau multicouche M de l'invention en fonction de sa température T interne en °C pour un rayonnement incident de longueur d'onde $\lambda$ compris entre 7,5 et 14 $\mu$m.

Le support 1 consiste en une feuille d'aluminium d'épaisseur 0,4 mm.

Des couches thermorégulées 2 d'épaisseurs différentes et de natures différentes, élaborées avec un dépôt sous vide dans des conditions différentes décrites ci-dessous suivies d'un recuit sous air à 600°C pendant 10 min ont été fabriquées. Puis on a mesuré leurs émissivités $\varepsilon$ respectives.

Plus spécifiquement, l'émissivité est obtenue en dérivant la courbe de caméra thermique, c'est-à-dire la température infrarouge en fonction de la température réelle dans une gamme de longueur d'onde $\lambda$ comprise entre 7,5 et 14 $\mu$m.

Tel qu'indiqué sur la figure 8, les mesures ont été effectuées pour des matériaux multicouches présentant les couches thermorégulées suivantes:

- LC (400 nm) représente un matériau multicouche présentant une couche thermorégulée 2 de cobaltite de lanthane déposée sous vide avec un plasma d'argon sans oxygène, présentant une épaisseur de 400 nm ;
- LCO (400 nm) représente un matériau multicouche présentant une couche thermorégulée 2 de cobaltite de lanthane oxydé déposée sous vide avec un plasma d'argon et d'oxygène, présentant une épaisseur de 400 nm ;
- LC (200 nm) représente un matériau multicouche présentant une couche thermorégulée 2 de cobaltite de lanthane déposée sous vide avec un plasma d'argon sans oxygène, présentant une épaisseur de 200 nm :
- LCO (200nm) représente un matériau multicouche présentant une couche thermorégulée 2 de cobaltite de lanthane oxydé déposée sous vide avec un plasma d'argon et d'oxygène, présentant une épaisseur de 200 nm.

Condition de dépôt sous vide avec un plasma d'argon sans oxygène à température ambiante:

Pression de travail : 0,5 Pa
Débits de gaz : 30 cm³/min d'Ar
Cibles La : générateur Pinacle3 (5,5 cm) 73 W
Cible Co : générateurMDX500 (7 cm) 57W
Vitesse de dépôt : 1800 nm/h

Condition de dépôt sous vide avec un plasma d'argon et d'oxygène à température ambiante :

Pression de travail : 0,5 Pa
Débits de gaz : 7 cm³/min d'$O_2$ et 30 cm³/min d'Ar
Cibles La : Pinacle3 (5,5 cm) 110 W
Cible Co : MDX500 (7 cm) 52W
Vitesse de dépôt : 200 nm/h

La figure 8 montre que l'émissivité $\varepsilon$ dépend de l'épaisseur de la couche thermorégulée 2. Dans le cas de l'expérience de la figure 8, si on double l'épaisseur de la couche thermorégulée 2, en passant de 200 à 400 nm, alors on double quasiment la valeur maximum de l'émissivité $\varepsilon$.

De la même manière, les conditions de dépôt sous vide avec plasma d'argon en présence ou en absence d'oxygène vont modifier la valeur de la variation d'émissivité Δε en fonction de la température. Si la couche thermorégulée 2 possède une épaisseur de 200nm, la variation de l'émissivité Δε est plus élevée pour un dépôt sous vide avec un plasma d'argon que pour un dépôt avec un plasma réactif argon/oxygène. Si on double l'épaisseur de la couche thermorégulée 2 à 400nm, la variation d'émissivité est augmentée, mais elle est similaire si on modifie l'atmosphère du dépôt : elle est de 59% pour un dépôt sous vide avec plasma argon et de 63% pour un dépôt avec un plasma argon oxygène.

Il est à noter, qu'une variation d'émissivité Δε pour un matériau, comprenant une couche thermorégulée sur un support approprié de l'invention, entraine une diminution de la température de stagnation dudit matériau multicouche.

La variation d'émissivité Δε d'un matériau dépend à la fois de l'interface optique ou interaction existante entre ledit support et ladite couche thermorégulée, ainsi que de la nature et de l'épaisseur du support, de la nature et de l'épaisseur de la couche thermorégulée.

En effet, pour un même support, la nature et l'épaisseur de la couche thermorégulée va modifier l'interaction entre le support et ladite couche thermorégulée, ainsi que les propriétés optiques générales du matériau multicouche.

Le devenir des rayons lumineux et, par conséquent, les propriétés optiques, vont dépendre de l'interface optique qui sépare le support et la couche thermorégulée. L'interaction entre ces deux milieux uniforme est fonction et résulte de la composition chimique qui détermine l'indice optique.

Par conséquent, l'interaction entre un support et une couche thermorégulée est spécifique à chaque couche thermorégulée, et de cette interaction, découlent des propriétés optiques ainsi qu'une variation d'émissivité Δε spécifiques du matériau multicouche.

En effet, toutes les couches thermochromes ou thermorégulées n'interagissent pas de la même manière avec un même support donc ne permettent pas d'obtenir une variation d'émissivité Δε conséquente, de préférence au moins supérieure à 40%, pour diminuer significativement la température de stagnation du matériau multicouche.

En d'autres termes, pour des propriétés optiques équivalentes entre deux couches thermorégulée d'épaisseur identiques que l'on dépose sur un support identique, la variation d'émissivité Δε qui résulte de chacun des matériaux multicouches obtenus sera différente et fonction de l'interaction spécifique entre le support et sa couche thermorégulée.

C'est pourquoi, de manière surprenante, les inventeurs ont mis en évidence, qu'une couche thermorégulée à base de perovskite d'épaisseur spécifique entre 50 et 500 nm selon l'invention avec un support selon l'invention présente une interaction et des propriétés physico-chimiques fortement améliorées par rapport au matériau multicouche traditionnel.

En conséquence, cette interaction améliorée permet d'augmenter la variation d'émissivité Δε du matériau multicouche de l'invention pour qu'elle dépasse les 40% et que la température de stagnation soit diminuée dans la gamme de température attendue.

Il a été constaté de manière avantageuse avec le matériau de l'invention, que la diminution de valeur de la température de stagnation équivaut au pourcentage de la valeur de variation d'émissivité Δε.

Par exemple, un Δε de 40% entraine une diminution de 40°C de la température de stagnation du capteur.

Ainsi, par rapport à l'art antérieur présentant une couche sélective de $VO_2$, le choix particulier d'une couche thermochrome de nature à base de pérovskite et d'épaisseur spécifique compris entre 50 et 500 nm présente plusieurs avantages :

- L'interaction avec le support mène bien à une augmentation de l'émissivité lorsque la température augmente ;
- La variation d'émissivité Δε est augmentée, elle est comprise entre 35% et 70% pour une pérovskite intrinsèque sans dopage, contrairement à un matériau avec du $VO_2$ où la variation d'émissivité Δε ne dépasse pas les 25% sans un dopage à l'aluminium;
- la température de stagnation du matériau est diminuée significativement d'une valeur d'au moins 35°C - 40°C en conséquence de la variation d'émissivité Δε, contrairement au $VO_2$ où la valeur de température de stagnation n'était diminuée au maximum que de 20°C
- la température critique de transition Tc, du matériau de l'invention à base pérovskite d'épaisseur compris entre 50 et 500 nm, est comprise entre 80°C et 120°C sans dopage, contrairement au $VO_2$ qui transite à 68°C ;
- la stabilité du matériau multicouche et sa résistance à l'oxydation est améliorée, en effet, la couche de pérovskite est stable à la corrosion, ce qui n'est pas le cas d'une couche de $VO_2$ qui présente des suroxydes tels que $V_4O_9$, $V_2O_5$,...

Ainsi, le matériau multicouche de conception simple de l'invention de par son épaisseur et la nature de sa couche thermochrome sont pérennes dans le temps, inoxydables. Ils possèdent, même sans dopage, des propriétés physico-chimiques améliorées par rapport à un matériau à base de $VO_2$, utilisables en particulier pour la conception des panneaux solaires.

En outre, la couche thermochrome doit également répondre aux normes en usage dans l'Union Européenne.

Ainsi, le matériau multicouche M de l'invention de conception plus simple que celui de l'art antérieur est apte à autoréguler ses capacités optiques en fonction de sa température interne T, c'est pourquoi il consiste en un matériau adéquat pour être utilisé en tant que panneau solaire thermique.

**Revendications**

1. Matériau multicouche thermorégulé (M) comprenant au moins :

   - Un support (1) ayant

     • un coefficient de transmission $\Gamma_s$ sensiblement égal à 0, pour des rayonnements de longueur d'onde $\lambda$ compris entre 0,25 et 25 $\mu$m ;
     • un coefficient de réflexion $\rho_s \geq 0,9$, pour des rayonnements incidents de longueur d'onde $\lambda$ compris entre 7,5 et 10 $\mu$m ;

   - une couche thermorégulée (2) d'épaisseur comprise entre 50 et 500 nm à base de pérovskites de cobaltites de terre rares ou de pérovskites de nickelates de terre rares ou de manganites de terre rares, ladite couche thermorégulée (2) surmontant une des surfaces dudit support (1) ;
   - ledit matériau multicouche (M) thermorégulé ayant :

     • pour des rayonnements de longueur d'onde $\lambda$ comprise entre 0,25 et 2,5 $\mu$m ; un coefficient d'absorption $\alpha m \geq 0,8$ ;
     • et, pour des rayonnements incidents de longueur d'onde $\lambda$ comprise entre 7,5 et 10 $\mu$m ; un coefficient de réflexion $\rho m$ :

       *** $\geq 0,85$, lorsque la température T dudit matériau multicouche (M) est $\leq 100$ °C ;
       *** compris entre 0,3 et 0,85, lorsque la température T dudit matériau multicouche (M) est comprise entre 100 et 400°C.

2. Matériau multicouche thermorégulé (M) selon la revendication précédente, **caractérisé en ce que** lesdits pérovskites sont de formule ABO3 :

   - Avec « A » étant au moins un élément chimique unique ou un groupement d'élément chimique appartenant au groupe des terres rares ;
   - Avec « B » étant soit du cobalt Co, soit du nickel Ni, soit du manganèse Mn et,
   - Avec « O3 » représentant trois oxygènes.

3. Matériau multicouche thermorégulé (M) selon la revendication précédente, **caractérisé en ce que** « A » correspond à au moins un élément chimique appartenant à la famille des terres rares, choisi parmi la liste suivante : le lanthane La ; le praséodyme Pr ; le néodyme Nd ; le samarium Sm ; le gadolinium Gd ou encore l'europium Eu.

4. Matériau multicouche thermorégulé (M) selon l'une quelconques des revendications 2 à 3, **caractérisé en ce que** ledit au moins un élément chimique « A » du perovskite de formule ABO3 est dopé partiellement avec au moins un élément chimique « E » de fraction atomique « z » compris entre 0,1 et 0,6, ledit élément « E » appartenant au groupe des alcalinoterreux choisi parmi la liste suivante: le strontium Sr ; le calcium Ca ou le baryum Ba, de sorte que la couche thermorégulé (2) soit de formule A1-zEzCoO3 ou A1-zEzNiO3 ou A1-zEzMnO3.

5. Matériau multicouche thermorégulé (M) selon l'une quelconques des revendications 2 à 4, **caractérisé en ce que** l'élément « B » du perovskite de formule ABO3 est dopé partiellement avec au moins un élément chimique « D » de fraction atomique « y » compris entre 0,1 et 0,5 ; ledit élément « D » appartenant au groupe des métaux de transition choisi parmi la liste suivante : le cobalte Co ; le nickel Ni ; le manganèse Mn ; le fer Fe ; le titan Ti ; le vanadium V ou encore le chrome Cr, de sorte que la couche sélective thermorégulé (2) soit de formule ACO1-yDyO3 ou ANi1-yDyO3 ou AMn1-yDyO3.

6. Matériau multicouche thermorégulé (M) selon l'une quelconque des revendications 2 à 5, **caractérisé en ce que** les oxygènes «O3» de la pérovskite de formule ABO3 sont dopés partiellement avec de l'azote N de fraction atomique « x » compris entre 0,03 et 1, de sorte que la couche thermorégulée (2) soit de formule ACoO3-xNx ou ANiO3-xNx ou AMn3-xNx.

**7.** Matériau multicouche thermorégulé (M) selon l'une quelconque des revendications 4 à 6, **caractérisé en ce que** la couche thermorégulée (2) de formule ABO3, comprenant au moins l'un de ces éléments « A », « B » ou « O3 » dopé partiellement :

   • est d'épaisseur comprise entre 300 et 500 nm et,
   • présente, pour des rayonnements incidents de longueur d'onde $\lambda$ compris entre 7,5 et 10 $\mu$m, un coefficient de transmission $\Gamma_T$:

      *** $\geq$ 0,95 pour une température interne de ladite couche thermorégulée (2) inférieure ou égale à 100°C ;
      *** $\leq$ 0,6 pour une température interne de ladite couche thermorégulée (2) comprise entre 100 et 200°C.

**8.** Matériau multicouche thermorégulé (M) selon l'une quelconque des revendications précédentes, **caractérisé en ce que** ledit support (1) consiste en une feuille métallique à base d'aluminium Al ou de cuivre Cu.

**9.** Matériau multicouche thermorégulé (M) selon l'une quelconque des revendications précédentes, **caractérisé en ce que** ladite couche thermorégulée (2) est recouverte d'une couche anti-reflet (3).

**10.** Matériau multicouche thermorégulé (M) selon l'une quelconque des revendications précédentes, **caractérisé en ce qu'**il comprend une couche barrière (4) apte à empêcher la diffusion à l'état solide d'éléments chimiques du support (1) vers la couche thermorégulée (2), ladite couche barrière (4) étant positionnée entre ledit support (1) et ladite couche thermorégulée (2).

**11.** Matériau multicouche thermorégulé (M) selon l'une quelconque des revendications précédentes ayant :

   • pour des rayonnements de longueur d'onde $\lambda$ comprise entre 0,25 et 2,5 pm ; un coefficient d'absorption $\alpha_m$ $\geq$ 0, 94 ;
   • et, pour des rayonnements incidents de longueur d'onde $\lambda$ comprise entre 7,5 et 10 $\mu$m ; un coefficient de réflexion $\rho_m$ :

      *** $\geq$ 0,92, lorsque la température T dudit matériau multicouche (M) est $\leq$ 100 °C ;
      *** $\leq$ 0,6 ; lorsque la température dudit matériau multicouche est $\geq$ 100°C.

**12.** Procédé de fabrication d'un matériau multicouche (M) selon l'une quelconque des revendications précédentes, dans lequel :

   - On dépose sur ledit support (1) par copulvérisation sous vide, en présence d'un plasma réactif d'argon et d'oxygène ou d'argon pur, une couche thermorégulée (2) de formule générale ABO$_3$ avec « A » étant au moins un élément chimique unique ou un groupement d'éléments chimiques appartenant au groupe des terres rares et « B » un métal de transition de type Ni, Mn ou Co,
   - On recuit ex situ le matériau obtenu précédemment à des températures comprises entre 525 et 800°C, de préférence 575 et 600°C pendant une durée comprise entre 30 secondes et 1 heure, de préférence entre 30 et 240 secondes.

**13.** Panneau solaire **caractérisé en ce qu'**il comprend un matériau multicouche thermorégulé selon l'une quelconque des revendications 1 à 11.

**Patentansprüche**

**1.** Thermoreguliertes Mehrschichtmaterial (M), umfassend mindestens:

   - einen Träger (1), der Folgendes aufweist:

      • einen Transmissionskoeffizienten $\Gamma_s$ im Wesentlichen gleich 0 für Strahlungen mit einer Wellenlänge $\lambda$ zwischen 0,25 und 25 $\mu$m;
      • einen Reflexionskoeffizienten $\rho_s$ $\geq$ 0,9 für einfallende Strahlungen mit einer Wellenlänge $\lambda$ zwischen 7,5 und 10 $\mu$m;

- eine Seltenerd-Cobaltit-Perowskiten- oder Seltenerd-Nickelat-Perowskiten- oder Seltenerd-Manganiten-basierte thermoregulierte Schicht (2) mit einer Dicke zwischen 50 und 500 nm, wobei die besagte thermoregulierte Schicht (2) über einer der Oberflächen des besagtem Trägers (1) liegt;
- wobei das besagte thermoregulierte Mehrschichtmaterial (M) Folgendes aufweist:

  • für Strahlungen mit einer Wellenlänge $\lambda$ zwischen 0,25 und 2,5 $\mu$m: einen Absorptionskoeffizienten $\alpha_m \geq$ 0,8;
  • und für einfallende Strahlungen mit einer Wellenlänge $\lambda$ zwischen 7,5 und 10 $\mu$m: einen Reflexionskoeffizienten $\rho_m$:

    *** $\geq$ 0,85, wenn die Temperatur T des besagten Mehrschichtmaterials (M) $\leq$ 100°C ist;
    *** zwischen 0,3 und 0,85, wenn die Temperatur T des Mehrschichtmaterials (M) zwischen 100 und 400°C liegt.

2. Thermoreguliertes Mehrschichtmaterial (M) nach dem vorhergehenden Anspruch, **dadurch gekennzeichnet, dass** die besagte Perovskite der Formel ABO3 sind:

   - wobei "A" mindestens ein einzelnes chemisches Element oder eine Gruppe von chemischen Elementen ist, die zur Gruppe der seltenen Erden gehören;
   - wobei "B" entweder Kobalt Co oder Nickel Ni oder Mangan Mn ist, und
   - wobei "O3" drei Sauerstoffatome darstellt.

3. Thermoreguliertes Mehrschichtmaterial (M) nach dem vorhergehenden Anspruch, **dadurch gekennzeichnet, dass** "A" mindestens einem chemischen Element entspricht, das zur Seltenerdfamilie gehört, die aus der folgenden Liste ausgewählt ist:

   Lanthan La; Praseodym Pr; Neodym Nd; Samarium Sm; Gadolinium Gd oder auch Europium Eu.

4. Thermoreguliertes Mehrschichtmaterial (M) nach irgendeinem der Ansprüche 2 bis 3, **dadurch gekennzeichnet, dass** das besagte mindestens eine chemische Element "A" des Perowskits der Formel ABO3 teilweise mit mindestens einem chemischen Element "E" mit einer Atomfraktion "z" zwischen 0,1 und 0,6 dotiert ist, wobei das besagte Element "E" zur Gruppe von Erdalkalimetallen gehört, die aus der folgenden Liste ausgewählt ist: Strontium Sr; Calcium Ca oder Barium Ba, so dass die thermoregulierte Schicht (2) der Formel A1-zEzCoO3 oder A1-zEzNiO3 oder A1-zEzMnO3 ist.

5. Thermoreguliertes Mehrschichtmaterial (M) nach irgendeinem der Ansprüche 2 bis 4, **dadurch gekennzeichnet, dass** das Element "B" des Perowskits der Formel ABO3 teilweise mit mindestens einem chemischen Element "D" mit einer Atomfraktion "y" zwischen 0,1 und 0,5 dotiert ist; wobei das besagte Element "D" zur Gruppe von Übergangsmetallen gehört, die aus der folgenden Liste ausgewählt ist:

   Cobalt Co; Nickel Ni; Mangan Mn; Eisen Fe; Titan Ti; Vanadium V oder auch Chrom Cr, so dass die thermoregulierte selektive Schicht (2) der Formel ACO1-yDyO3 oder ANi1-yDyO3 oder AMn1-yDyO3 ist.

6. Thermoreguliertes Mehrschichtmaterial (M) nach irgendeinem der Ansprüche 2 bis 5, **dadurch gekennzeichnet, dass** die Sauerstoffatome "O3" des Perowskits der Formel ABO3 teilweise mit Stickstoff N mit einer Atomfraktion "x" zwischen 0,03 und 1 dotiert ist, so dass die thermoregulierte Schicht (2) der Formel ACoO3-xNx oder ANiO3-xNx oder AMn3-xNx ist.

7. Thermoreguliertes Mehrschichtmaterial (M) nach irgendeinem der Ansprüche 4 bis 6, **dadurch gekennzeichnet, dass** die thermoregulierte Schicht (2) der Formel ABO3, die mindestens eines dieser teilweise dotierten Elemente "A", "B" oder "O3" umfasst:

   • eine Dicke zwischen 300 und 500 nm aufweist, und
   • für einfallende Strahlungen mit einer Wellenlänge $\lambda$ zwischen 7,5 und 10 $\mu$m: einen Reflexionskoeffizienten $\Gamma_T$ aufweist:

     *** $\geq$ 0,95, für eine Innentemperatur der besagten thermoregulierten Schicht (2) von weniger als oder gleich 100°C;

*** ≤ 0,6 für eine Innentemperatur der besagten thermoregulierten Schicht (2) zwischen 100 und 200°C.

8. Thermoreguliertes Mehrschichtmaterial (M) nach irgendeinem der vorhergehenden Ansprüche, **dadurch gekennzeichnet, dass** der besagte Träger (1) aus einer Aluminium Al- oder Kupfer Cu-basierten Metallfolie besteht.

9. Thermoreguliertes Mehrschichtmaterial (M) nach irgendeinem der vorhergehenden Ansprüche, **dadurch gekennzeichnet, dass** die besagte thermoregulierte Schicht (2) mit einer Antireflexionsschicht (3) bedeckt ist.

10. Thermoreguliertes Mehrschichtmaterial (M) nach irgendeinem der vorhergehenden Ansprüche, **dadurch gekennzeichnet, dass** es eine Sperrschicht (4) umfasst, die geeignet ist, die Diffusion im festen Zustand von chemischen Elementen des Trägers (1) zur thermoregulierten Schicht (2) zu verhindern, wobei die besagte Sperrschicht (4) zwischen dem besagten Träger (1) und der besagten thermoregulierten Schicht (2) positioniert ist.

11. Thermoreguliertes Mehrschichtmaterial (M) nach irgendeinem der vorhergehenden Ansprüche, das Folgendes aufweist:

    • für Strahlungen mit einer Wellenlänge $\lambda$ zwischen 0,25 und 2,5 $\mu$m: einen Absorptionskoeffizienten $\alpha_m \geq 0,94$;
    • und für einfallende Strahlungen mit einer Wellenlänge $\lambda$ zwischen 7,5 und 10 $\mu$m: einen Reflexionskoeffizienten $\rho_m$:

    *** ≥ 0,92, wenn die Temperatur T des besagten Mehrschichtmaterials (M) ≤ 100°C beträgt;
    *** ≤ 0,6, die Temperatur des besagten Mehrschichtmaterials (M) ≥ 100°C beträgt.

12. Verfahren zur Herstellung eines mehrschichtigen Materials (M) nach irgendeinem der vorhergehenden Ansprüche, wobei:

    - auf dem besagten Träger (1) durch Co-Sprühen unter Vakuum in Gegenwart eines reaktiven Argon- und Sauerstoff- oder reinen Argon-Plasmas eine thermoregulierte Schicht (2) der allgemeinen Formel $ABO_3$ abgeschieden wird, wobei "A" mindestens ein einzelnes chemisches Element oder eine Gruppe von chemischen Elementen ist, die zur Gruppe der seltenen Erden gehören, und "B" ein Übergangsmetall der Art Ni, Mn oder Co ist,
    - das zuvor erhaltene Material ex situ bei Temperaturen zwischen 525 und 800°C, vorzugsweise 575 und 600°C für einen Zeitraum zwischen 30 Sekunden und 1 Stunde, vorzugsweise zwischen 30 und 240 Sekunden, getempert wird.

13. Solarmodul, **dadurch gekennzeichnet, dass** es ein thermoreguliertes Mehrschichtmaterial nach irgendeinem der Ansprüche 1 bis 11 umfasst.

**Claims**

1. A thermoregulated multilayer material (M), comprising :

    - A support (1) having

        • a transmission coefficient $\Gamma_s$ substantially equal to 0, for rays with a wavelength A of between 0.25 and 25 pm;
        • a reflection coefficient $\rho s \geq 0.9$, for incident rays with wavelength A of between 7.5 and 10 pm;

    - a thermoregulated layer (2) with a thickness of between 50 and 500 nm with a base of rare earth perovskite cobaltites or rare earth perovskite nickelates or rare earth manganites, said thermoregulated layer (2) topping one of the surfaces of said support (1);
    - said thermoregulated material (M) having:

        • for rays with wavelength A of between 0.25 and 2.5 pm; an absorption coefficient $\alpha m \geq 0.8$;
        • and, for incident rays with wavelength A of between 7.5 and 10 pm; a reflection coefficient $\rho_m$:

        *** ≥ 0.85, when the temperature T of said multilayer material (M) is ≤ 100°C;

*** between 0.3 and 0.85, when the temperature T of said multilayer material (M) is between 100 and 400°C.

2. The thermoregulated multilayer material (M) according to the preceding claim, **characterized in that** said perovskites have formula ABO3:

- With "A" being at least one single chemical element or a group of chemical elements belonging to the rare earths group;
- With "B" being either cobalt Co, or nickel Ni, or manganese Mn, and
- With "O3" representing three oxygens.

3. The thermoregulated multilayer material (M) according to the preceding claim, **characterized in that** "A" corresponds to at least one chemical element belonging to the rare earths family chosen from the following list: lanthanum La; praseodymium Pr; neodymium Nd; samarium Sm; gadolinium Gd or europium Eu.

4. The thermoregulated multilayer material (M) according to any one of claims 2 to 3, **characterized in that** said at least one chemical element "A" of the perovskite with formula $ABO_3$ is partially doped with at least one chemical element "E" of atomic fraction "z" of between 0.1 and 0.6, said element "E" belonging to the alkaline-earth group chosen from the following list: strontium Sr; calcium Ca or barium Ba, such that the thermoregulated layer (2) has formula $A_{1-z}E_zCoO_3$ or $A_{1-z}E_zNiO_3$ or A1-zEzMnO3.

5. The thermoregulated multilayer material (M) according to any one of claims 2 to 4, **characterized in that** the element "B" of the perovskite with formula $ABO_3$ is partially doped with at least one chemical element "D" of atomic fraction "y" of between 0.1 and 0.5; said element "D" belonging to the transition metals group chosen from the following list: cobalt Co; nickel Ni; manganese Mn; iron Fe; titanium Ti; vanadium V or chromium Cr, such that the thermoregulated selective layer (2) has formula $ACO_{1-y}D_yO_3$ or $ANi_{1-y}D_yO_3$ or $AMn_{1-y}D_yO_3$.

6. The thermoregulated multilayer material (M) according to any one of claims 2 to 5, **characterized in that** the oxygens "$O_3$" of the perovskite with formula ABO3 are partially doped with nitrogen N with atomic fraction "x" of between 0.03 and 1, such that the thermoregulated layer (2) has formula $ACoO_{3-x}N_x$ or $ANiO_{3-x}N_x$ or $AMn_{3-x}N_x$.

7. The thermoregulated multilayer material (M) according to any one of claims 4 to 6, **characterized in that** the thermoregulated layer (2) with formula ABO3, comprising at least one of these elements "A", "B" or partially doped "$O_3$":

• has a thickness of between 300 and 500 nm, and
• has, for incident rays with wavelength A of between 7.5 and 10 pm, a transmission coefficient $\Gamma_T$:

*** $\geq 0.95$ for an internal temperature of said thermoregulated layer (2) less than or equal to 100°C;
*** $\leq 0.6$ for an internal temperature of said thermoregulated layer (2) of between 100 and 200°C.

8. The thermoregulated multilayer material (M) according to any one of the preceding claims, **characterized in that** said support (1) consists of a metal sheet with a base of aluminum Al or copper Cu.

9. The thermoregulated multilayer material (M) according to any one of the preceding claims, **characterized in that** said thermoregulated layer (2) is covered with an antiglare layer (3).

10. The thermoregulated multilayer material (M) according to any one of the preceding claims, **characterized in that** it comprises a barrier layer (4) able to prevent the diffusion in solid state of chemical elements of the support (1) toward the thermoregulated layer (2), said barrier layer (4) being positioned between said support (1) and said thermoregulated layer (2).

11. The thermoregulated multilayer material (M) according to any one of the preceding claims, having:

• for rays with wavelength A of between 0.25 and 2.5 pm; an absorption coefficient $\alpha m \geq 0.94$;
• and, for incident rays with wavelength A of between 7.5 and 10 pm; a reflection coefficient $\rho_m$:

*** $\geq 0.92$, when the temperature T of said multilayer material (M) is $\leq 100$°C;

*** $\leq$ 0.6; when the temperature of said multilayer material is $\geq$ 100°C.

12. A method for manufacturing a thermoregulated multilayer material (M) according to any one of the preceding claims, in which:

- A thermoregulated layer (2) with general formula $ABO_3$ is deposited on said support (1) by vacuum co-sputtering, in the presence of a reactive plasma of argon and oxygen or of pure argon, with "A" being at least one single chemical element or a group of chemical elements belonging to the rare earths group and "B" being a transition metal of type Ni, Mn or Co,
- The material previously obtained is annealed ex situ at temperatures of between 525 and 800°C, preferably 575 and 600°C for a duration of between 30 seconds and 1 hour, preferably between 30 and 240 seconds.

13. A solar panel, **characterized in that** it comprises a thermoregulated multilayer material according to any one of the claims 1 to 11.

FIG 1

FIG 2

FIG 3

$$\alpha = \frac{\int_{0,25}^{2,5}[1-R(\lambda)].S(\lambda)\,d\lambda}{\int_{0,25}^{2,5}S(\lambda).d\lambda} = 0,835$$

R(λ): évolution du coefficient de réflexion en fonction de la longueur d'onde λ
S(λ): spectre solaire en fonction de la longueur d'onde λ
α: coefficient d'absorption de l'énergie solaire pour 0,25 < λ < 2,5μm

FIG 4

3

2

1

FIG 5

2

4

1

FIG 6

3

2

4

1

FIG 7

La-Co et La-Co-O / Al : recuits à 600°C – 5×2min

Variation de l'émissivité lors de la descente en température (dérivée calculée à partir des courbes fitées)

LC-07 (400 nm) Δε=59%

LCO-02 (400 nm) Δε=63%

LC-04 (200 nm) Δε=35%

LCO-01 (200 nm) Δε=25%

Emmissivité

Température (°C)

FIG 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014140499 A